# EUROPEAN PATENT APPLICATION

(11) **EP 4 016 604 A1**
(43) Date of publication of application: **22.06.2022**
(21) Application number: 21195930.9
(22) Date of filing: 10.09.2021
(51) Int. Cl.: H01L 23/00, H01L 49/02, H01L 23/16, H01L 25/16

(54) **STIFFENER AND SOCKET EMBEDDED METAL INSERT ARCHITECTURES FOR POWER DELIVERY**

(30) Priority: 21.12.2020 US 202017129838
(71) Applicant: INTEL Corporation, Santa Clara, CA 95054 (US)
(72) Inventor: Jain, Amit Kumar, Sherwood 97140 (US); Shekhar, Sameer, Portland 97229 (US); Kamgaing, Telesphor, Chandler 85249 (US); Kuan, Chin Lee, 28700 Pahang (MY); Saxena, Vivek, San Ramon 94582 (US)
(74) Representative: Goddar, Heinz J.

(57) **Abstract**

Embodiments disclosed herein include electronic packages with stiffeners. In an embodiment, a stiffener for an electronic package comprises a first layer, that is conductive, and a second layer over the first layer, where the second layer is insulative. In an embodiment, the stiffener further comprises a third layer over the second layer, where the third layer is conductive. In an embodiment, the stiffener further comprises a leg attached to the third layer, where the leg extends towards the first layer and is substantially coplanar with a surface of the first layer opposite from the second layer.

## Description

### TECHNICAL FIELD

Embodiments of the present disclosure relate to electronic packaging systems, and more particularly to power delivery architectures that utilize a stiffener and/or a socket embedded metal insert.

### BACKGROUND

Power delivery is becoming an ever increasingly complex aspect of electronic packaging. One particular concern in power delivery of advanced packaging solutions is loadline reduction for fully integrated voltage regulator (FIVR) input supply (VCCIN) or core input supply for motherboard voltage regulator (MBVR) and integrated LDO based solutions. Particularly, VCCIN loadline limits the available voltage at the FIVR input. The conventional solution to reduce loadline is higher package layers, higher board layers, and/or increases in bulk capacitance. However, such solutions result in a larger Z-height and an increase in the cost of assembly.

An additional power delivery issue is the need for capacitance. Typically capacitance is provided by land side components. To accommodate the height of the land side components, a recess is provided in the motherboard. This increases the complexity of the motherboard and increases cost. Additionally, the cost of individual capacitors to provide the needed capacitance increases the cost of the system.

### BRIEF DESCRIPTION OF THE DRAWINGS

Figure 1A is a plan view illustration of an electronic package with a die surrounded by a power delivery stiffener, in accordance with an embodiment.
Figure 1B is a perspective view illustration of a portion of the power delivery stiffener, in accordance with an embodiment.
Figure 1C is a perspective view illustration of a portion of the power delivery stiffener, in accordance with an additional embodiment.
Figure 2 is a plan view illustration of an electronic package with disaggregated dies that are fed power from a single power delivery stiffener, in accordance with an embodiment.
Figure 3A is a plan view illustration of an electronic package with a plurality of power delivery stiffener rings around the die, in accordance with an embodiment.
Figure 3B is a plan view illustration of an electronic package with a plurality of power delivery stiffener rings around the die, in accordance with an additional embodiment.
Figure 4 is a perspective view illustration of a power delivery sheet embedded in a socket, in accordance with an embodiment.
Figure 5A is a cross-sectional illustration of an electronic package with a power delivery stiffener that comprises a capacitor, in accordance with an embodiment.
Figure 5B is a plan view illustration of the electronic package with a power delivery stiffener, in accordance with an embodiment.
Figures 6A-6F are illustrations depicting a process for forming a power delivery stiffener that comprises a capacitor, in accordance with an embodiment.
Figure 6G is a plan view illustration of an electronic package with a power delivery stiffener that comprises a capacitor, in accordance with an embodiment.
Figure 7A is a cross-sectional illustration of an electronic package with a power delivery stiffener that comprises a cavity for housing capacitors, in accordance with an embodiment.
Figure 7B is a plan view illustration of the electronic package with a power delivery stiffener, in accordance with an embodiment.
Figure 8 is a schematic of a computing device built in accordance with an embodiment.

### EMBODIMENTS OF THE PRESENT DISCLOSURE

Described herein are power delivery architectures that utilize a stiffener and/or a socket embedded metal insert, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, power delivery is an ever growing design problem in electronic packaging applications. Typically power issues are handled by increasing the number of routing layers in the package substrate. However, the increase in cost and Z-height of the package substrate caused by adding layers is not acceptable in some systems. Additionally, in die disaggregation architectures, the presence of embedded bridges in the package substrate further restricts power delivery performance.

Accordingly, embodiments disclosed herein repurpose existing components of the electronic package for power delivery applications. In one embodiment, the stiffener is modified in order to provide power delivery. Particularly, power and ground planes may be provided on the stiffener instead of using a monolithic grounded stiffener. The thickness of the stiffener may be approximately 300µm compared to approximately 15µm for the copper layers in the package substrate. As such, using a stiffener to augment the input power plane can dramatically reduce the package resistance part of the loadline. In some embodiments, the use of a power delivery stiffener may result in an approximately 30% loadline reduction. In the case of socketed package architectures, a conductive plate may be embedded in the socket body in order to reduce the lateral impedance on the board and the package substrate.

In yet another embodiment, the stiffener may be repurposed to provide capacitance to the system. Instead of a single metal plane, the stiffener may have conductive layers separated from each other by a high-k dielectric material. In some embodiments, the capacitance provided by the stiffener may be sufficient to provide all of the needed capacitance for the system. As such, land side capacitors may be omitted, and there is no need for recesses in the motherboard. Therefore, the cost of the electronic package is reduced since capacitors can be omitted, and the complexity of the board fabrication is reduced.

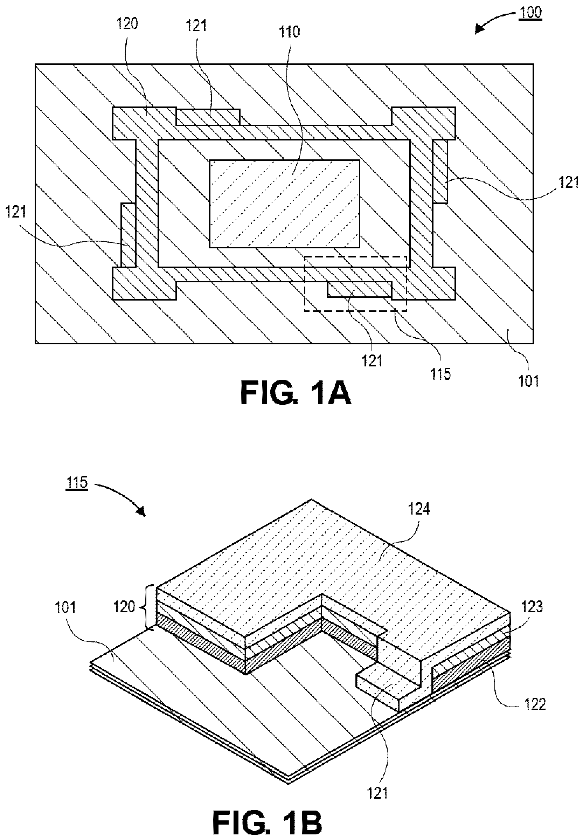

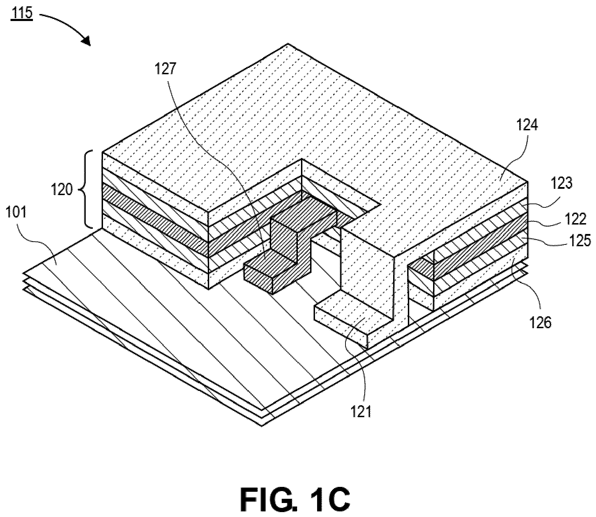

Referring now to Figure 1, a plan view illustration of an electronic package 100 is shown, in accordance with an embodiment. In an embodiment, the electronic package 100 may comprise a package substrate 101. The package substrate 101 may comprise organic layers and conductive routing (not shown). In an embodiment, a die 110 is attached to the package substrate 101. The die 110 may be any suitable die, such as a processor, a graphics processor, a system on a chip (SoC), a memory, or the like.

In an embodiment, the die 110 is surrounded by a stiffener 120. The stiffener 120 provides mechanical support to the package substrate 101 in order to decrease warpage. In a particular embodiment, the stiffener 120 may be referred to as a power delivery stiffener. That is, the power delivery stiffener 120 may provide a power plane for supplying power to the electronic package 100. The architecture of the power delivery stiffener 120 is described in greater detail below.

In an embodiment, the stiffener 120 may comprise one or more legs 121. The legs 121 provide an electrical connection from the top of the stiffener 120 to the package substrate. In the illustrated embodiment, four legs 121 are provided. However, it is to be appreciated that the stiffener 120 may comprise any number of legs 121. In an embodiment, the legs 121 are provided adjacent to an outer surface of the stiffener. In other embodiments, one or more of the legs 121 may be provided on an interior surface of the stiffener 120. The dashed box highlights a region 115 that comprises a leg 121. Figure 1B is a sectional illustration of the region 115 in order to more clearly illustrate the structure of the stiffener 120.

As shown in Figure 1B, the stiffener 120 comprises a plurality of layers 122, 123, and 124. The first layer 122 may be an electrically conductive layer such as copper. In an embodiment, the first layer 122 may be used as a power plane. That is, the first layer 122 may be a VCCIN power plane. The first layer 122 may be electrically coupled to the package substrate 101 at one or more locations by an electrically conductive adhesive (ECA) through a solder resist opening of the package substrate 101. In an embodiment, the second layer 123 may be an electrically insulative layer, such as an oxide or an electrically insulating polymer material. In an embodiment, the third layer 124 may be an electrically conductive layer, such as copper. In an embodiment, the third layer 124 may be a ground plane. That is, the stiffener 120 comprises a first layer 122 at a first voltage (e.g., VCCIN) and a third layer 124 at a second voltage (e.g., VSS).

In an embodiment, the third layer 124 may be electrically coupled to the package substrate 101 by a leg 121. The leg 121 comprises an extension out from the third layer 124 that wraps down along the side of the second layer 123 and the first layer 122. In some embodiments, the leg 121 may be a monolithic structure with the third layer 124. A bottom surface of the leg 121 may be substantially coplanar with the bottom surface of the first layer 122. The leg 121 may be electrically coupled to the package substrate 101 by an ECA through a solder resist opening of the package substrate 101. In the particular embodiment illustrated in Figure 1B, the leg 121 comprises a first bend down the side of the stiffener 120 and a second bend to provide a surface for attaching the leg 121 to the package substrate 101. As illustrated in Figure 1B, the double bend structure of the leg 121 may resemble the structure of a step. The step may be spaced away from the sidewalls of the first layer 122 and the second layer 123 in order to provide electrical isolation between the first layer 122 and the third layer 124.

In an embodiment, the stiffener 120 may have a total thickness that is approximately 250µm or greater. The individual layers 122, 123, 124 may have thicknesses that are approximately 50µm or greater. This thickness is significantly greater than the thickness of routing layers in the package substrate 101, which are commonly approximately 15µm. As such, the resistance along the power delivery stiffener 120 is significantly lower than if the power and ground planes were provided in the package substrate 101. Additionally, moving the power and ground planes out of the package substrate 101 reduces the number of layers needed for the package substrate 101. The use of the stiffener 120 for power delivery purposes does not increase the Z-height of the electronic package 100 since a stiffener 120 is also needed for mechanical reasons.

Referring now to Figure 1C, a perspective view illustration of the region 115 is shown, in accordance with an additional embodiment. In Figure 1C, the stiffener 120 comprises additional layers. Particularly, a fourth layer 125 is below the first layer 122, and a fifth layer 126 is below the fourth layer 125. In an embodiment, the fourth layer 125 is an electrically insulating layer, and the fifth layer 126 is an electrically conductive layer. The fifth layer 126 may also be held at the ground potential (e.g., VSS). As such, the first layer 122 is electrically shielded from above by the third layer 124 and from below by the fifth layer 126.

The addition of the fourth layer 125 and the fifth layer 126 results in the first layer 122 being raised up off of the package substrate 101. As such, a leg 127 may provide an electrical connection from the package substrate 101 to the first layer 122. The leg 127 may have a pair of bends to provide a step-like structure with a bottom surface that is substantially coplanar with the bottom surface of the fifth layer 126. The leg 127 may be electrically coupled to the package substrate 101 by an ECA through a solder resist opening in the package substrate 101. Similarly, a leg 121 may provide an electrical connection from the third layer 124 to a package substrate 101. The leg 121 may be electrically coupled to the package substrate 101 by an ECA through a solder resist opening in the package substrate 101. In an embodiment, the fifth layer 126 may be electrically connected to the package substrate 101 through an ECA through a solder resist opening in the package substrate 101.

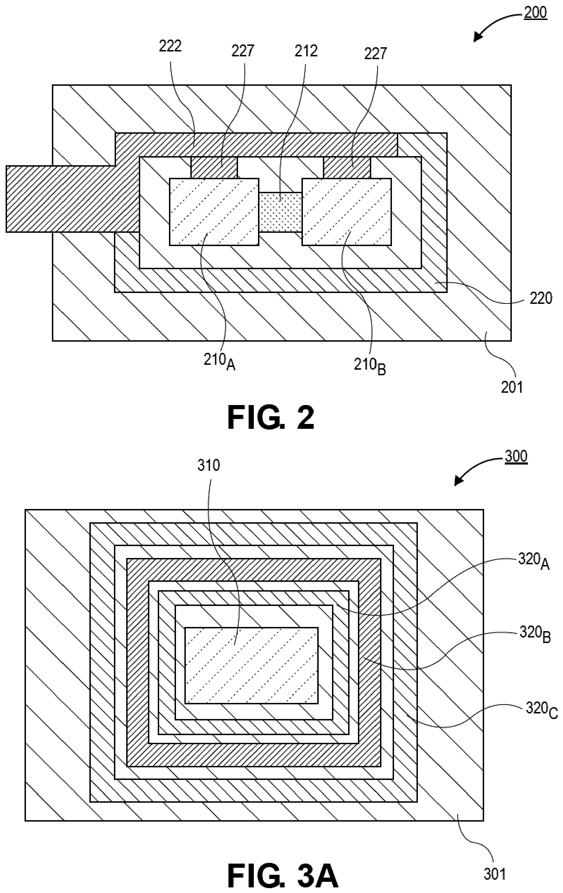

Referring now to Figure 2, a plan view illustration of an electronic package 200 is shown, in accordance with an embodiment. In an embodiment, the electronic package 200 comprises a pair of dies 210_{A} and 210_{B} that are surrounded by a stiffener 220. The dies 210_{A} and 210_{B} may be electrically coupled to each other by an embedded bridge 212, such as an embedded multi-die interconnect bridge (EMIB) architecture. The embedded bridge 212 results in the loss of package routing layers. Accordingly, power may be delivered over the stiffener 220 instead of through package layers.

In an embodiment, the stiffener 220 may comprise a power delivery layer 222 that is electrically coupled to both dies 210_{A} and 210_{B}. Such an architecture is beneficial when key power supplies are used to power both dies (e.g., for computation logic or IO). In an embodiment, the stiffener 220 may have a layer stack-up similar to the embodiment shown in Figure 1B or Figure 1C. For example, the stiffener 220 may comprise a power delivery layer 222 and a ground layer (not shown), or the stiffener 220 may comprise a power delivery layer 222 that is shielded above and below by a pair of ground layers (not shown). As shown in Figure 2, the power delivery layer 222 may be electrically coupled to the package substrate 201 through legs 227. The use of legs 227 is necessary when the power delivery layer 222 is not the bottommost layer of the stiffener 220. In the case where the power delivery layer 222 is the bottommost layer of the stiffener 220 (e.g., similar to the stack-up in Figure 1B), the legs 227 may be omitted.

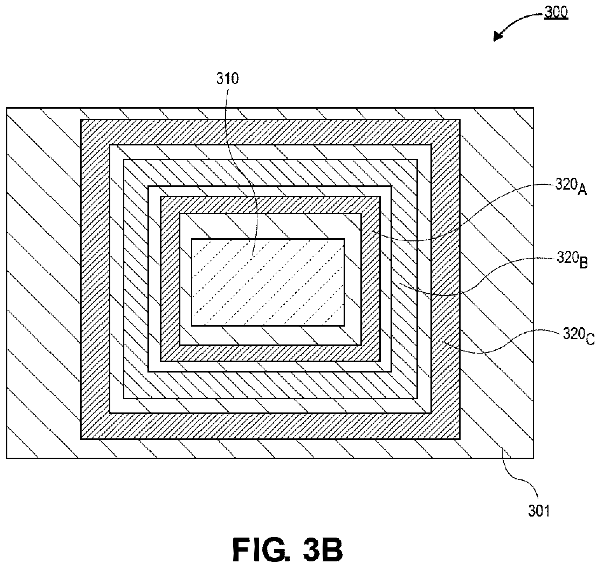

Referring now to Figures 3A and 3B, a series of plan view illustrations of electronic packages 300 are shown in accordance with additional embodiments. In Figures 3A and 3B, a die 310 on a package substrate 301 is surrounded by a plurality of stiffeners 320_{A}, 320_{B}, and 320_{C}. In the embodiment shown in Figure 3A, the first stiffener 320_{A} and the third stiffener 320_{c} may be held at ground potential (e.g., VSS), and the second stiffener 320_{B} may be a power delivery voltage (e.g., VCCIN). In the embodiment shown in Figure 3B, the first stiffener 320_{A} and the third stiffener 320_{C} may be held at power delivery voltages (e.g., VCCIN), and the second stiffener 320_{B} may be held at ground potential (e.g., VSS). Providing the different voltages in a coplanar configuration may simplify the complexity of the stiffeners 320 and may reduce costs, compared to stacking them as shown in Figure 1B and Figure 1C. In an embodiment, the stiffeners 320_{A}, 320_{B}, and 320_{C} may be electrically coupled to the package substrate 301 through an ECA that passes through a solder resist layer.

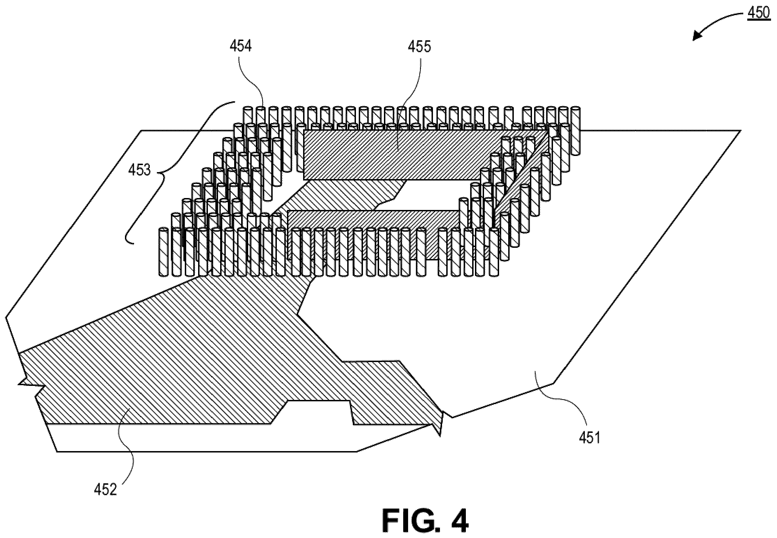

Referring now to Figure 4, a perspective illustration of an electronic system 450 is shown, in accordance with an embodiment. In an embodiment, a socket 453 is connected to a board 451. The body of the socket 453 is omitted to not obscure the embedded features, such as the pins 454 and the conductive plate 455. The socket 453 may provide a connection between a package substrate (not shown) and the board 451.

As shown in Figure 4, a power plane 452 is provided on the board 451. The power plane 452 provides a power connection to pins on a first side of the socket 453 (bottom side in Figure 4) and a second side of the socket 453 (top side in Figure 4). Additionally, the power plane 452 may be electrically coupled to the conductive plate 455. The conductive plate 455 may be embedded in the body of the socket 453 between the pins 454. The conductive plate 455 may have a relatively high thickness substantially equal to the socket height (e.g., up to approximately 2,000µm). As such, a low resistance path is provided to power pins 454 on the top side (as viewed in Figure 4) of the socket 453. This reduces impedance and improves performance of the electronic system 450.

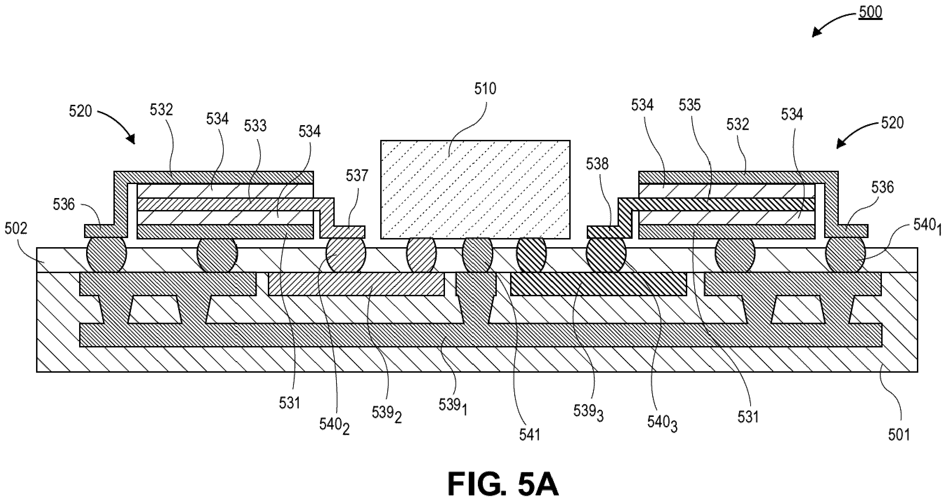

Referring now to Figures 5A-7B power delivery stiffeners that comprise capacitors are shown and described, in accordance with various embodiments. In an embodiment, the capacitors are integrated into the structure of the stiffener. In other embodiments, discrete capacitors are housed within a cavity in the stiffener.

Referring now to Figure 5A, a cross-sectional illustration of an electronic package 500 is shown, in accordance with an embodiment. In an embodiment, the electronic package comprises a package substrate 501 and a die 510 connected to the package substrate 501 by solder bumps 541. In an embodiment, a stiffener 520 is provided around a perimeter of the die 510. The stiffener 520 may comprise a multi-layer high-k capacitor. The capacitor may have a first voltage output at leg 537 and a second voltage output at leg 538. That is, the stiffener 520 may comprise a pair of capacitors. In other embodiments, the stiffener 520 may have a single capacitor or a plurality of capacitors.

In an embodiment, the capacitor on the left and the capacitor on the right comprise a first layer 531, a second layer 533/535, and a third layer 532. The first layer 531 and the third layer 532 may be ground layers. The first layer 531 and the third layer 532 may be connected to traces 539₁ in the package substrate 501. The third layer 532 may have a leg 536 that provides a connection to the package substrate 501. An ECA 540₁ provides an electrical connection through a solder resist layer 502 to the traces 539₁.

In an embodiment, the capacitor on the left comprises a second layer 533. The second layer 533 is an electrically conductive layer that is separated from the first layer 531 and the third layer 532 by high-k dielectric layers 534. The high-k dielectric layers may be any suitable high-k dielectric material such as materials with a k-value equal to or greater than the k-value of silicon dioxide. The second layer 533 may comprise a leg 537 that is electrically connected to trace 539₂ by an ECA 540₂.

In an embodiment, the capacitor on the right comprises a second layer 535. The second layer 535 is an electrically conductive layer that is separated from the first layer 531 and the third layer 532 by high-k dielectric layers 534. The second layer 535 may comprise a leg 538 that is electrically connected to trace 539₃ by an ECA 540₃.

In the illustrated embodiment, the different shading of the conductive features indicate different voltages along the lines. For example, the shading of traces 539₁ indicate a ground potential (e.g., VSS), the shading of trace 539₂ indicates a first power potential (e.g., VCC1), and the shading of trace 539₃ indicates a second power potential (e.g., VCC2).

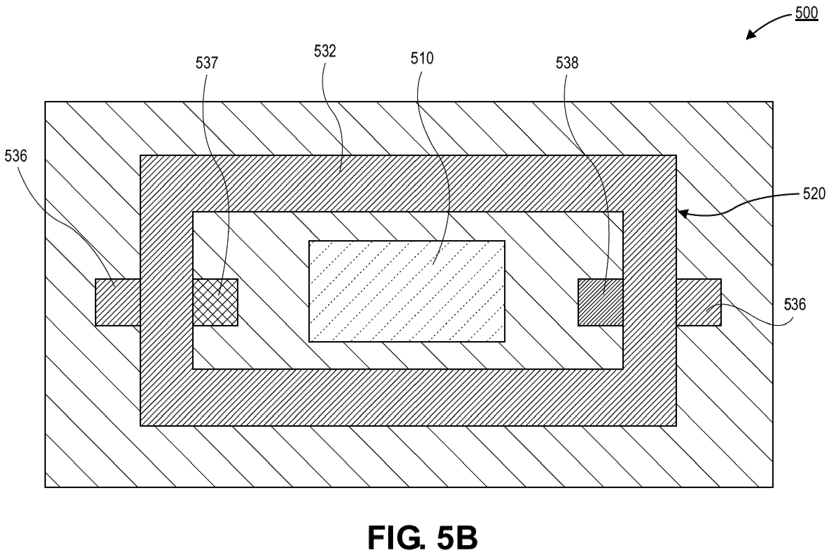

Referring now to Figure 5B, a plan view illustration of the electronic package 500 is shown, in accordance with an embodiment. As shown, the stiffener 520 forms a ring that surrounds a perimeter of the die 510. The top surface of the stiffener 520 may be the third layer 532. As shown, legs 536 extend away from the third layer 532 to provide a connection to the package substrate 501 below the solder resist 502. On the interior surface of the stiffener 520, legs 537 and 538 extend away from the stiffener 520 to provide a connection for the different power voltages. In order to electrically isolate leg 537 from leg 538 an electrical break is provided in the second layer (not visible in Figure 5B). In embodiments where only a single power voltage is provide, the second layer may be a continuous ring. Additionally, if there are more than two power voltages provided, multiple electrical breaks may be provided in the second layer.

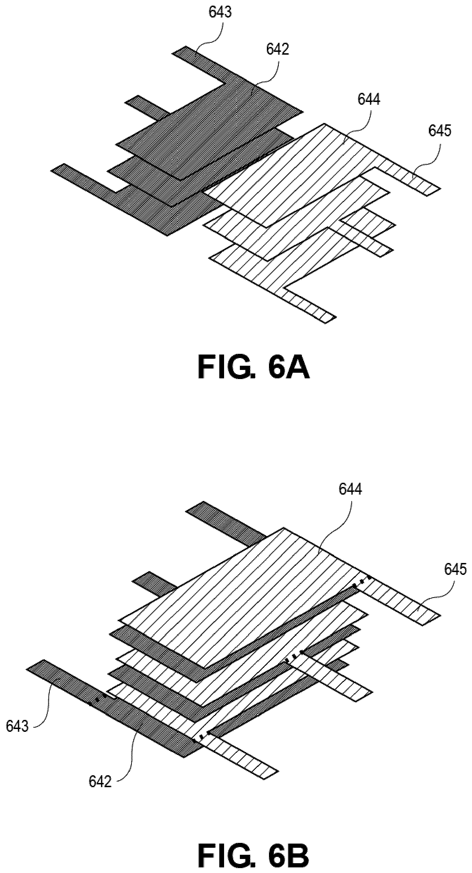

Referring now to Figures 6A-6F, a series of illustrations depicting a process to form a stiffener with an integrated capacitor is shown, in accordance with an embodiment.

Referring now to Figure 6A, a perspective view illustration of a plurality of first layers 642 and a plurality of second layers 644 is shown, in accordance with an embodiment. The first layers 642 may have extensions 643 and the second layers 644 may have extensions 645. In Figure 6A, the first layers 642 and the second layer 644 are shown as pads. However, it is to be appreciated that each of the first layers 642 and the second layers 644 may be rings to form the shape of a stiffener. The first layers 642 and the second layers 644 may be conductive material, such as copper.

Referring now to Figure 6B, a perspective view illustration of after the first layers 642 are interleaved with the second layers 644 is shown, in accordance with an embodiment. In an embodiment, a high-k dielectric may be provided between each of the first layers 642 and the second layers 644 to provide a capacitor structure. The high-k dielectric is omitted in the picture in order to not obscure the conductive layers.

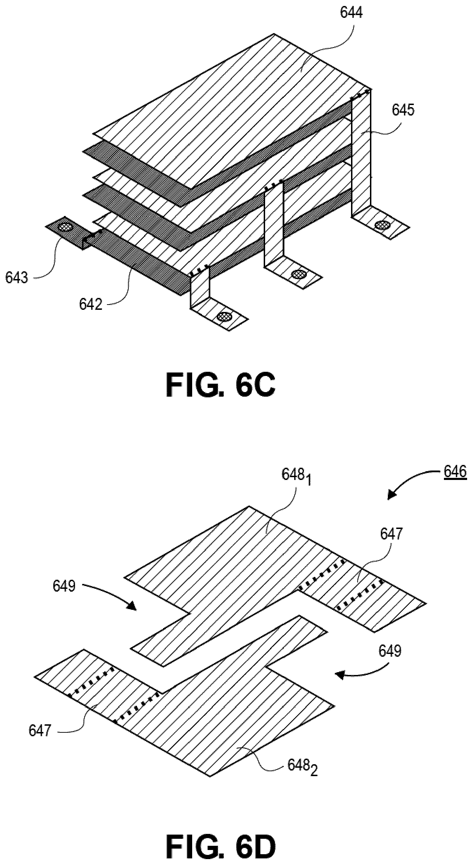

Referring now to Figure 6C, an illustration after the extensions 645 and 643 are bent in order to provide vertical electrical connections is shown, in accordance with an embodiment. The extensions 645 and 643 are configured to provide an electrical connection to an underlying package substrate (not shown). While bent extensions 643 and 645 are shown, it is to be appreciated that alternative vertical connection architectures may be used to provide electrical coupling of each layer to an underlying substrate.

Referring now to Figure 6D, an illustration of portions of an outer shell 646 of the stiffener is shown, in accordance with an embodiment. In an embodiment, the outer shell 646 may comprise a top portion 648₁ and a bottom portion 648₂. The top portion 648₁ and the bottom portion 648₂ may comprise extensions 647. The extensions 647 may be aligned with a notch 649 in the opposing portion 648 of the outer shell 646.

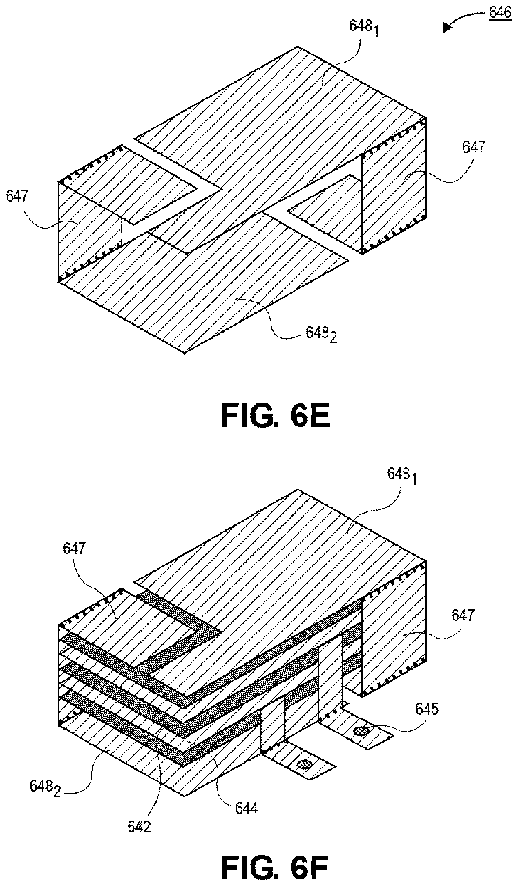

Referring now to Figure 6E, an illustration of the outer shell 646 after the extensions 647 are bent into shape is shown, in accordance with an embodiment. As shown, the bent extensions 647 end up partially filling the notches 649 in the opposing portion 648. The bent extensions 647 provide improved mechanical rigidity to the outer shell 646.

Referring now to Figure 6F, an illustration of the outer shell surrounding the first layers 642 and the second layers 644 is shown, in accordance with an embodiment. As shown, the extension 645 bend down to provide electrical connections to an underlying substrate (not shown). The extensions 647 bend around the first layers 642 and the second layers 644. In an embodiment, the outer shell is a stainless steel or other rigid material. In some embodiments, the outer shell may be grounded.

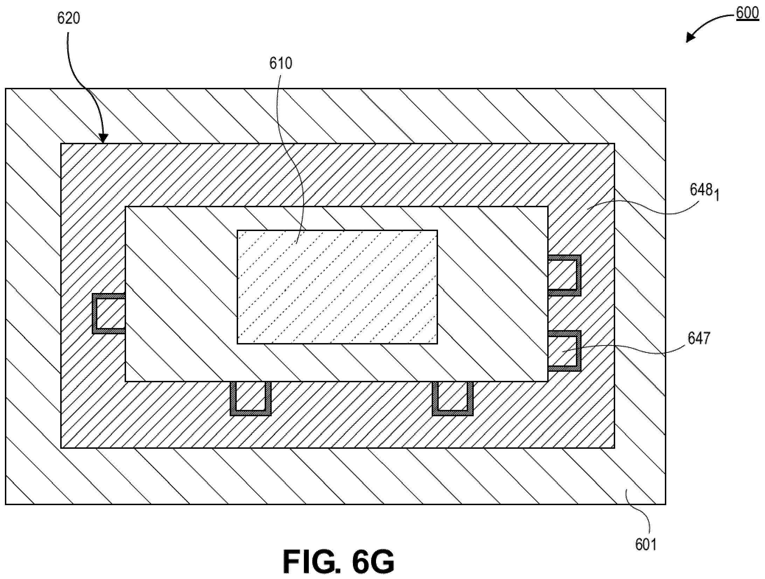

Referring now to Figure 6G, a plan view illustration of an electronic package 600 with a stiffener 620 around a die 610 and over a package substrate 601 is shown, in accordance with an embodiment. The stiffener 620 may be substantially similar to the stiffener assembled in Figures 6A-6F. The top portion 648₁ is shown, with extensions 647 bending up and around the capacitor layers (below the top portion 648₁).

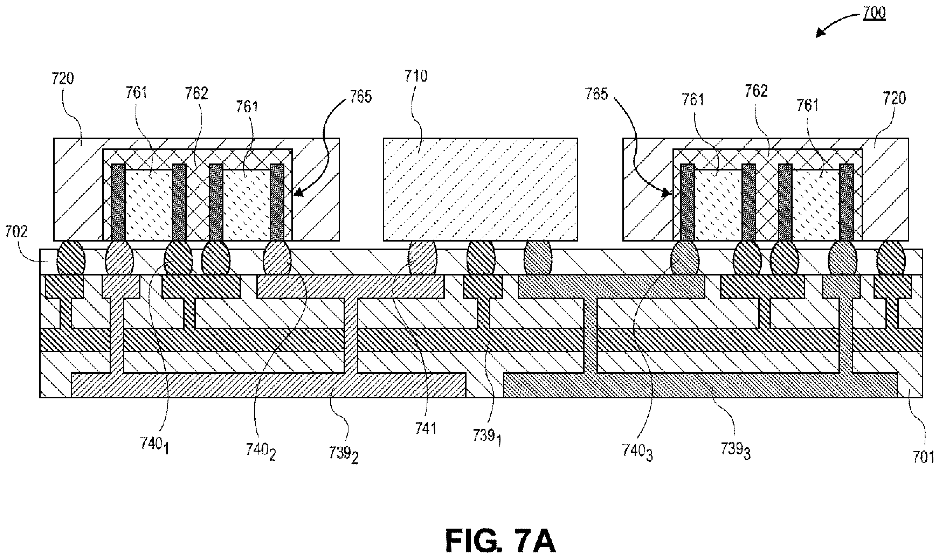

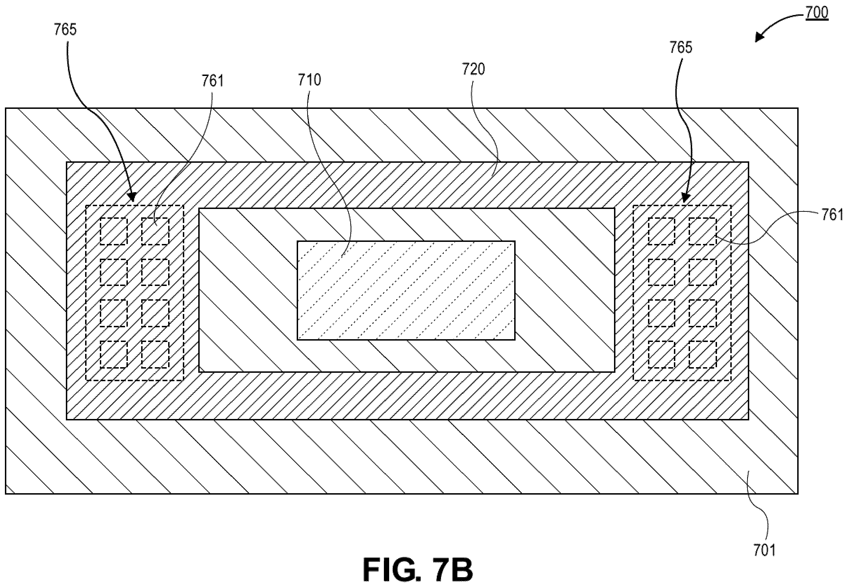

Referring now to Figures 7A and 7B, illustrations of an electronic package 700 with a stiffener 720 with cavities for discrete capacitors 761 are shown in accordance with an embodiment. The electronic package 700 comprises a package substrate 701 with a solder resist layer 702. A die 710 is electrically coupled to the package substrate 701 by interconnects 741, such as solder balls.

In an embodiment, a stiffener 720 surrounds a perimeter of the die 710. The stiffener 720 may be a conductive material, such as stainless steel or the like. In an embodiment, the stiffener 720 comprises one or more cavities 765. The cavities 765 may be sized to receive one or more discrete capacitors 761. The capacitors 761 may be secured in the cavity 765 by a molding compound 762.

In an embodiment, the capacitors 761 are electrically coupled to the die 710 through conductive traces 739 in the package substrate 701. In the illustrated embodiment, the capacitors 761 on the left side provide a first voltage to the die 710 (as indicated by the similar shading of the interconnect 740₂ and the traces 739₂). The other terminals of the capacitors 761 on the left may be ground terminals (as indicated by the similar shading of interconnects 740₁ and traces 739₁). In an embodiment, the capacitors 761 on the right side provide a second voltage to the die 710 (as indicated by the similar shading of the interconnect 740₃ and the traces 739₃). In an embodiment, the stiffener 720 may be electrically grounded.

Referring now to Figure 7B, a plan view illustration of the electronic package 700 is shown, in accordance with an embodiment. As shown by the dashed lines, a pair of cavities 765 are provided in the stiffener 720. While two cavities 765 are shown, it is to be appreciated that any number of cavities 765 may be used to provide the needed space for discrete capacitors. In an embodiment, eight capacitors 761 are provided in each cavity 765. However, it is to be appreciated that any number of capacitors 761 may be provided in each cavity 765.

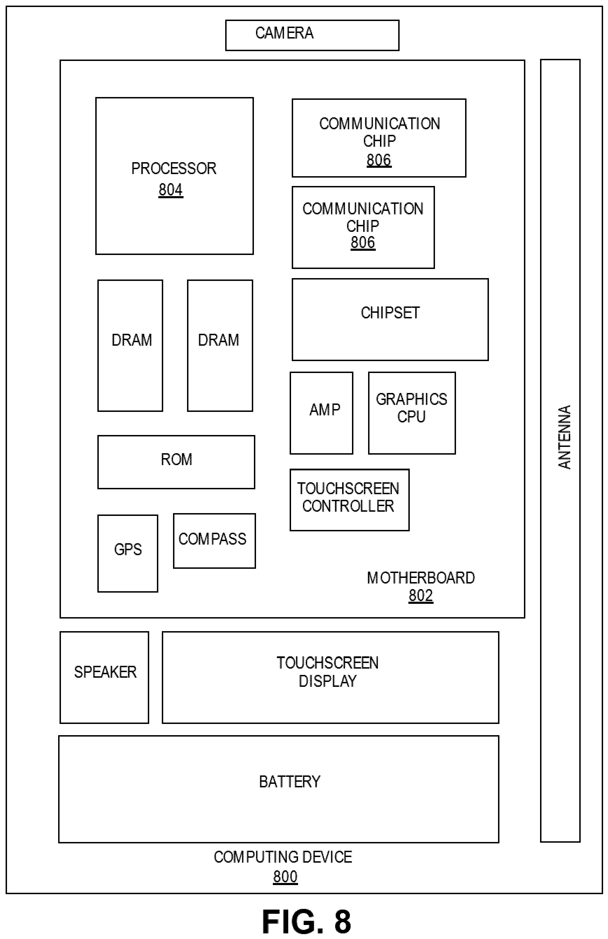

Figure 8 illustrates a computing device 800 in accordance with one implementation of the invention. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of the invention, the integrated circuit die of the processor may be part of an electronic package that comprises a stiffener that is used as a power delivery component and/or a socket that includes an embedded metal sheet, in accordance with embodiments described herein. The term "processor" may refer to any device or portion of a device that processes electronic data from registers and/or memory to transform that electronic data into other electronic data that may be stored in registers and/or memory.

The communication chip 806 also includes an integrated circuit die packaged within the communication chip 806. In accordance with another implementation of the invention, the integrated circuit die of the communication chip may be part of an electronic package that comprises a stiffener that is used as a power delivery component and/or a socket that includes an embedded metal sheet, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

Example 1: a stiffener for an electronic package, comprising: a first layer, wherein the first layer is conductive; a second layer over the first layer, wherein the second layer is insulative; a third layer over the second layer, wherein the third layer is conductive; and a leg attached to the third layer, wherein the leg extends towards the first layer and is substantially coplanar with a surface of the first layer opposite from the second layer.

Example 2: the stiffener of Example 1, wherein the first layer, the second layer, and the third layer are rings with an interior edge and an exterior edge.

Example 3: the stiffener of Example 2, wherein the leg is provided adjacent to the exterior edge.

Example 4: the stiffener of Examples 1-3, wherein the leg is one leg in a plurality of legs that extend towards the first layer and are substantially coplanar with the surface of the first layer opposite from the second layer.

Example 5: the stiffener of Examples 1-4, wherein the leg and the third layer are a monolithic structure.

Example 6: the stiffener of Example 5, wherein the leg comprises a first bend and a second bend.

Example 7: the stiffener of Examples 1-6, further comprising: a fourth layer over the third layer, wherein the fourth layer is an insulating material; a fifth layer over the fourth layer, wherein the fifth layer is a conductive material; and a second leg attached to the fifth layer, wherein the second leg extends towards the first layer and is substantially coplanar with the surface of the first layer opposite from the second layer.

Example 8: the stiffener of Example 7, wherein the first layer and the fifth layer are configured to be connected to a first voltage source, and wherein the third layer is configured to be connected to a second voltage source.

Example 9: the stiffener of Example 8, wherein the first voltage source is a ground, and wherein the second voltage source is a power supply.

Example 10: an electronic package, comprising: a package substrate; a die attached to the package substrate; and a stiffener surrounding the die, wherein the stiffener comprises: a first layer, wherein the first layer is a conductive material, and wherein the first layer is electrically coupled to the package substrate; a second layer over the first layer, wherein the second layer is an insulating material; a third layer over the second layer, wherein the third layer is a conductive material; and a leg attached to the third layer and electrically coupled to the package substrate.

Example 11: the electronic package of Example 10, further comprising: a second die surrounded by the stiffener, wherein the stiffener further comprises: a second leg attached to the third layer and electrically coupled to the package substrate, wherein the leg is electrically coupled to the die, and wherein the second leg is electrically coupled to the second die.

Example 12: the electronic package of Example 10 or Example 11, further comprising: a socket attached to the package substrate, wherein the socket comprises: a plurality of pins; and a conductive sheet between the plurality of pins.

Example 13: the electronic package of Example 12, wherein the conductive sheet has a height greater than the height of the plurality of pins.

Example 14: the electronic package of Example 12 or Example 13, wherein the conductive sheet is configured to short circuit a power or ground plane on a board attached to the socket.

Example 15: a stiffener for an electronic package, comprising: an outer shell; and a capacitor within the outer shell.

Example 16: the stiffener of Example 15, wherein the outer shell comprises: a first layer over the capacitor; and a second layer below the capacitor, wherein the first layer comprises a first arm that wraps around the capacitor and is coplanar with the second layer, and wherein the second layer comprises a second arm that wraps around the capacitor and is coplanar with the first layer.

Example 17: the stiffener of Example 15, wherein the capacitor comprises: a first electrode; a first dielectric layer over the first electrode; a second electrode over the first dielectric layer; a second dielectric layer over the second electrode; and a third electrode over the second dielectric layer.

Example 18: the stiffener of Example 17, wherein the second electrode has a first leg, wherein the third electrode has a second leg, and wherein bottom surfaces of the first leg and the second leg are substantially coplanar.

Example 19: the stiffener of Example 17, wherein the second electrode comprises a first region and a second region, wherein the first region is electrically isolated from the second region.

Example 20: the stiffener of Examples 15-19, wherein the outer shell comprises a cavity, and wherein the capacitor is positioned in the cavity.

Example 21: the stiffener of Example 20, wherein the capacitor is secured in the cavity by a mold layer.

Example 22: the stiffener of Examples 15-21, wherein the outer shell is a ring.

Example 23: an electronic package, comprising: a package substrate; a die on the package substrate; and a stiffener surrounding the die, wherein the stiffener comprises: an outer shell; and a capacitor within the outer shell.

Example 24: the electronic package of Example 23, wherein the outer shell is grounded.

Example 25: the electronic package of Example 23 or Example 24, wherein the capacitor comprises: a first electrode; a first dielectric layer over the first electrode; a second electrode over the first dielectric layer; a second dielectric layer over the second electrode; and a third electrode over the second dielectric layer.

## Claims

1. A stiffener for an electronic package, comprising:
a first layer, wherein the first layer is conductive;
a second layer over the first layer, wherein the second layer is insulative;
a third layer over the second layer, wherein the third layer is conductive; and
a leg attached to the third layer, wherein the leg extends towards the first layer and is substantially coplanar with a surface of the first layer opposite from the second layer.

2. The stiffener of claim 1, wherein the first layer, the second layer, and the third layer are rings with an interior edge and an exterior edge.

3. The stiffener of claim 2, wherein the leg is provided adjacent to the exterior edge.

4. The stiffener of claim 1, 2 or 3, wherein the leg is one leg in a plurality of legs that extend towards the first layer and are substantially coplanar with the surface of the first layer opposite from the second layer.

5. The stiffener of claim 1, 2, 3 or 4, wherein the leg and the third layer are a monolithic structure.

6. The stiffener of claim 5, wherein the leg comprises a first bend and a second bend.

7. The stiffener of claim 1, 2, 3, 4, 5 or 6, further comprising:
a fourth layer over the third layer, wherein the fourth layer is an insulating material;
a fifth layer over the fourth layer, wherein the fifth layer is a conductive material; and
a second leg attached to the fifth layer, wherein the second leg extends towards the first layer and is substantially coplanar with the surface of the first layer opposite from the second layer.

8. The stiffener of claim 7, wherein the first layer and the fifth layer are configured to be connected to a first voltage source, and wherein the third layer is configured to be connected to a second voltage source.

9. The stiffener of claim 8, wherein the first voltage source is a ground, and wherein the second voltage source is a power supply.

10. A method of fabricating a stiffener for an electronic package, the method comprising:
forming a first layer, wherein the first layer is conductive;
forming a second layer over the first layer, wherein the second layer is insulative;
forming a third layer over the second layer, wherein the third layer is conductive; and
forming a leg attached to the third layer, wherein the leg extends towards the first layer and is substantially coplanar with a surface of the first layer opposite from the second layer.

11. The method of claim 11, wherein the first layer, the second layer, and the third layer are rings with an interior edge and an exterior edge.

12. The method of claim 12, wherein the leg is provided adjacent to the exterior edge.

13. The method of claim 11, 12 or 13, wherein the leg is one leg in a plurality of legs that extend towards the first layer and are substantially coplanar with the surface of the first layer opposite from the second layer.

14. The method of claim 11, 12, 13 or 14, wherein the leg and the third layer are a monolithic structure.

15. The method of claim 14, wherein the leg comprises a first bend and a second bend.
